# EUROPEAN PATENT APPLICATION

(11) **EP 1 054 437 A2**
(43) Date of publication of application: **22.11.2000**
(21) Application number: 00110663.2
(22) Date of filing: 18.05.2000
(51) Int. Cl.: H01L 21/00

(54) **Method and apparatus for attaching wafer to wafer frame and planarization apparatus including attaching apparatus**

(30) Priority: 21.05.1999 JP 14138199
(71) Applicant: TOKYO SEIMITSU CO.,LTD., Mitaka-shi Tokyo (JP)
(72) Inventor: Ishikawa, Toshihiko, Mitaka-shi, Tokyo (JP); Katagiri, Yasushi, Mitaka-shi, Tokyo (JP)
(74) Representative: Hering, Hartmut, Dipl.-Ing.

(57) **Abstract**

The reverse of a wafer (W), of which obverse is covered with a masking tape (T), is adhered to a wafer sheet (S), which is adhered to a wafer frame (F) in particular for dicing. Then, the masking tape (T) is separated from the wafer (W). Thus, without damaging the wafer (W), the wafer (W) can be attached to the wafer frame (F) in particular for dicing and the masking tape (T) can be separated from the wafer (W).

## Description

The present invention generally relates to a method and apparatus for attaching a wafer to a wafer frame and a planarization apparatus including the attaching apparatus, particularly to a method and apparatus for attaching a wafer of which reverse is processed by the planarization apparatus to the wafer frame in particular for dicing, and the planarization apparatus including the attaching apparatus.

Necessity for miniaturizing electronic equipment has increasingly arisen, and electronic devices constructing the electronic equipment have been required to be even smaller in size. For achieving such miniaturization of the electronic devices, semiconductor chips constructing the circuit must be miniaturized as well. In particular, a thickness of the electronic devices that are mounted in various electronic cards is required to be extremely thin (e.g., 30-50 micrometers). The chips are formed by dicing a semiconductor wafer, on which circuits are formed, by a dicing machine. The semiconductor wafer before dicing must be thinner in order to make the thin chips. Hence, the reverse of the semiconductor wafer, on which no circuit is formed, is thinned by grinding, polishing, or etching by a planarization apparatus, before dicing the semiconductor wafer by the dicing machine.

The planarization apparatus grinds, polishes, and/or etches the reverse of the semiconductor wafer with a grindstone, a polishing cloth, and a chemical solution, respectively, while the obverse of the wafer is held by a chuck table. Therefore, the circuits, which are formed on the obverse of the wafer, are apt to be damaged or stained during processing. In view of this problem, a masking tape is adhered to the obverse of the semiconductor wafer while processing.

The semiconductor wafer with the masking tape adhered to its obverse must be separated from the masking tape after the process for the reverse is completed and before the next process, that is, dicing. Conventionally, the obverse of the semiconductor wafer of which the reverse is completed the process is first separated from the masking tape, and then the reverse of the wafer is adhered to a wafer sheet of the wafer frame for dicing.

In accordance with the conventional procedure, however, as adhering the semiconductor wafer of which the reverse is completed the process to the wafer sheet of the wafer frame for dicing, the semiconductor wafer is sometimes damaged when separating the masking tape if the semiconductor wafer is extremely thin. Therefore, the operation for separating the masking tape is extremely difficult to be automated, and conventionally a worker separates the masking tape by hand, which is inefficient.

The present invention has been developed in view of the above-described circumstances, and has as its object the provision of a method and apparatus for attaching a wafer to a wafer frame and a planarization apparatus including the attaching apparatus in which separating the masking tape from the wafer and attaching the wafer to the wafer frame for dicing can be performed without damaging the wafer.

In order to achieve the above-identified object, the present invention is directed to a method for attaching a wafer to a wafer frame for dicing, a masking tape being attached on an obverse of the wafer, the method comprising the steps of: adhering a reverse of the wafer to a wafer sheet adhered to the wafer frame; and then separating the masking tape from the wafer.

According to the present invention, the masking tape is separated from the wafer while the reverse, on which no masking tape is adhered, is adhered to the wafer sheet that is adhered to the wafer frame for dicing. Thus, the wafer that is considerably thin is not broken when being separated from the masking tape. The wafer is always handled in the state where the wafer is protected by some protection member; and hence, the wafer is not broken during transportation.

Preferably, the method further comprises the step of: before the adhering step, processing the reverse of the wafer by a planarization apparatus, the masking tape being attached on the obverse of the wafer.

In order to achieve the above-identified object, the present invention is directed to a wafer attaching apparatus which attaches a wafer to a wafer frame for dicing, a masking tape being attached on an obverse of the wafer, the apparatus comprising: a wafer sheet adhering device which adheres a reverse of the wafer to a wafer sheet adhered to the wafer frame; and a masking tape separating device which separates the masking tape from the wafer adhered to the wafer sheet.

Preferably, the wafer attaching apparatus further comprises a transporting device which transports the wafer from a planarization apparatus to the wafer attaching apparatus, the reverse of the wafer being processed by the planarization apparatus.

In order to achieve the above-identified object, the present invention is directed to a planarization apparatus which processes a reverse of the wafer, a masking tape being attached on an obverse of the wafer, comprising a wafer attaching apparatus which attaches a wafer to a wafer frame for dicing, a masking tape being attached on an obverse of the wafer, the wafer attaching apparatus comprising: a wafer sheet adhering device which adheres a reverse of the wafer to a wafer sheet adhered to the wafer frame; and a masking tape separating device which separates the masking tape from the wafer adhered to the wafer sheet.

According to the present invention, the planarization apparatus includes the wafer attaching apparatus, and the wafers of which reverses have been processed by the planarization apparatus can be successively attached to the wafer frames for dicing. Thus, the wafers can be efficiently processed.

### BRIEF DESCRIPTION OF THE DRAWINGS

The nature of this invention, as well as other objects and advantages thereof, will be explained in the following with reference to the accompanying drawings, in which like reference characters designate the same or similar parts throughout the figures and wherein:
Figs. 1(a)-1(e) are explanatory views of a method for attaching a wafer to a wafer frame according to an embodiment of the present invention;
Fig. 2 is a plan view showing the construction of an embodiment of the wafer attaching apparatus;
Fig. 3 is a side view showing the construction of an adhesion part of a wafer sheet; and
Fig. 4 is a side view showing the construction of a separation part of a masking tape.

Hereunder a preferred embodiment will be described of the method and apparatus for attaching a wafer to a wafer frame and a planarization apparatus including the attaching apparatus of the present invention with reference to the accompanying drawings.

An embodiment of the method for attaching the wafer to the wafer frame will be initially described.

As mentioned above, during a process for the reverse of a semiconductor wafer, the obverse of the wafer is held by a chuck table while a masking tape is adhered to the obverse in order to protect circuits formed on the obverse.

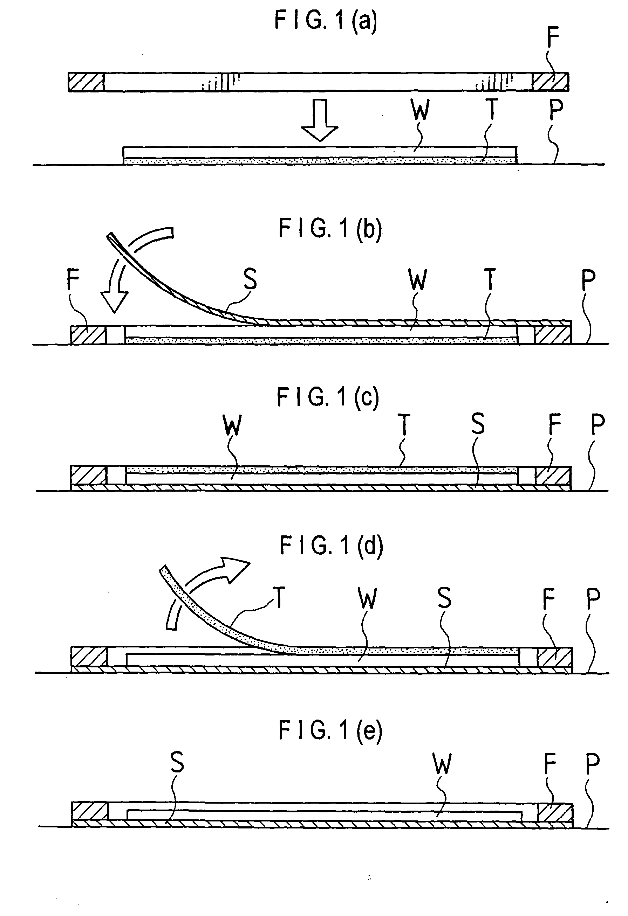

First, as shown in Fig. 1(a), a semiconductor wafer W is mounted at a predetermined position of a stage P. At this process, the semiconductor wafer W is mounted with its obverse, over which a masking tape T is adhered, turned down. Then a wafer frame F for dicing is positioned and mounted at the predetermined position with respect to the semiconductor wafer W.

Next, as shown in Fig. 1(b), a wafer sheet S is adhered to the wafer frame F and the reverse of the semiconductor wafer W, and the remaining outer peripheral portion of the wafer sheet S is cut off.

After that, as shown in Fig. 1(c), the wafer frame F to which the wafer sheet S is adhered is turned over, and the obverse of the semiconductor wafer W, over which the masking tape T is adhered, is thereby turned up.

Then, as shown in Fig. 1(d), the masking tape T is separated from the obverse of the semiconductor wafer W. At this process, the reverse of the semiconductor wafer W is held by the wafer sheet S, so that the semiconductor wafer W is not broken or chipped even though the masking tape T is peeled from the obverse of the semiconductor wafer W.

Through the above-described procedure, the semiconductor wafer W is adhered to the predetermined position of the wafer frame F as shown in Fig. 1(e).

As described above, according to the method for attaching the wafer of the present embodiment, the masking tape T is peeled from the semiconductor wafer W after adhering the semiconductor wafer W to the wafer sheet S; thus the semiconductor wafer W is not easily broken.

Next, a description will be given of an embodiment of the apparatus for attaching the wafer to the wafer frame of the present invention.

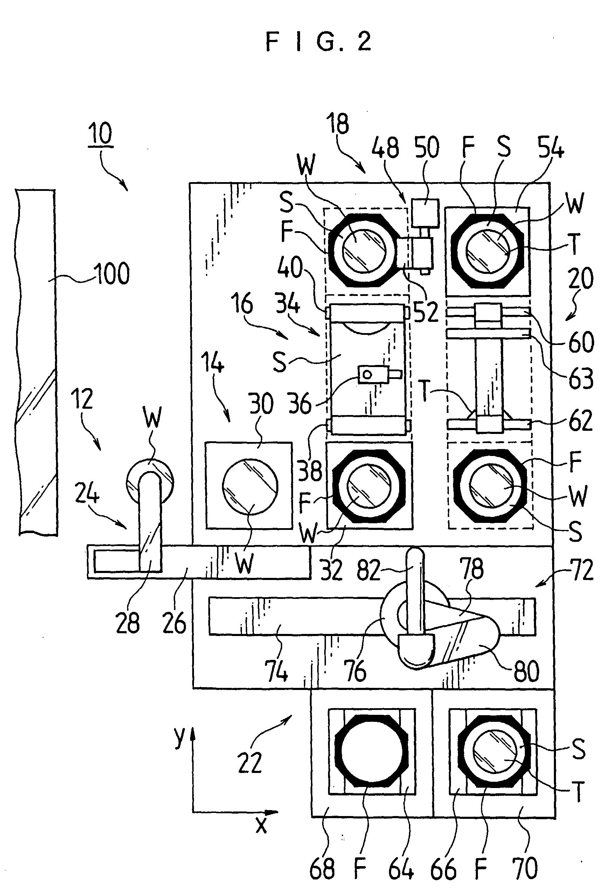

Fig. 2 is a plan view showing a construction of a wafer attaching apparatus 10 of the present embodiment. The wafer attaching apparatus 10 comprises a wafer transport part 12, an ultraviolet (UV) radiation part 14, a wafer sheet adhesion part 16, a wafer frame turning part 18, a masking tape separation part 20, and a wafer frame supply/collection part 22.

The wafer transport part 12 carries the semiconductor wafer W from an adjacent planarization apparatus 100 into the wafer attaching apparatus 10. The wafer transport part 12 is provided with a wafer handling robot 24. The wafer handling robot 24 has an arm 28, which reciprocally moves on a guide rail 26 in the x-direction in Fig. 2. The semiconductor wafer W is held to a pad (not shown), which is provided to the tip of the arm 28, and brought in the wafer attaching apparatus 10. After that, the wafer W is transported between the UV radiation part 14 and the wafer sheet adhesion part 16.

The UV radiation part 14 radiates UV light on the obverse of the semiconductor wafer W. At this process, the adhesive of the masking tape T that is adhered to the obverse of the semiconductor wafer W is hardened due to the action of the UV rays, and thus the masking tape T can be easily peeled from the obverse of the semiconductor wafer W The UV radiation part 14 is provided with a UV radiation unit 30, which radiates the UV light to the bottom face of the semiconductor wafer W transported to a predetermined UV radiation position by the wafer handling robot 24.

The wafer sheet adhesion part 16 adheres the wafer sheet S to the wafer frame F. The wafer sheet adhesion part 16 has a first moving table 32, a wafer sheet adhering device 34, and a wafer sheet cutting device 36.

The first moving table 32 carries the semiconductor wafer W and the wafer frame F and moves in the y-direction in Fig. 2 so as to move among a wafer receiving position, a wafer sheet adhesion position, and a wafer frame delivery position.

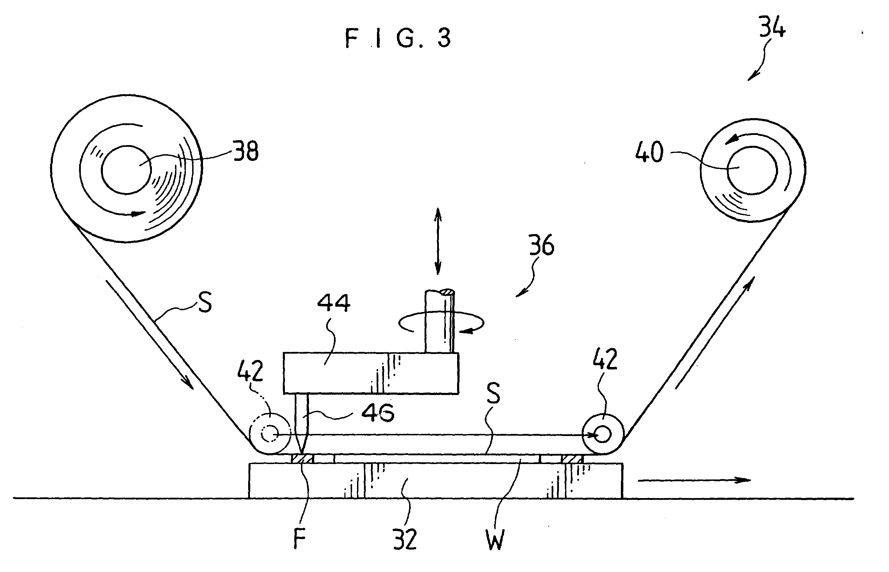

As shown in Fig. 3, the wafer sheet adhering device 34 has a wafer sheet supply roller 38, around which a strip of wafer sheet S is wound, a wafer sheet take-up roller 40, which winds up the wafer sheet S that is fed from the wafer sheet supply roller 38, and a wafer sheet press roller 42, which presses the wafer sheet S against the semiconductor wafer W and the top face of the wafer frame F so as to adhere the wafer sheet S. The wafer sheet S that is fed from the wafer sheet supply roller 38 with the adhering face turned down is pressed and adhered by the wafer sheet press roller 42 against the semiconductor wafer W and the top face of the wafer frame F between the wafer sheet supply roller 38 and the wafer sheet take-up roller 40.

The wafer sheet cutting device 36 has a cutting arm 44, which is rotatable as well as vertically movable. The cutting arm 44 is provided with a blade 46, which cuts the wafer sheet S that is adhered to the wafer frame F to remove the remaining outer periphery of the wafer sheet S.

The wafer frame turning part 18 turns the wafer frame F, to which the wafer sheet S is adhered, upside down. The wafer frame turning part 18 is provided with a wafer frame turning device 48. The wafer frame turning device 48 has a damper 52 mounted to an output shaft of a rotary actuator 50. The damper 52 holds a side of the wafer frame and is rotated by 180°, and the wafer frame F is thereby turned over.

The masking tape separation part 20 separates the masking tape T, which is adhered to the obverse of the semiconductor wafer W. The masking tape separation part 20 has a second moving table 54 and a masking tape separating device 56. The second moving table 54 carries the wafer frame F and moves in the y-direction in Fig. 3 among the wafer frame receiving position, the masking tape separation position, and the wafer delivery position.

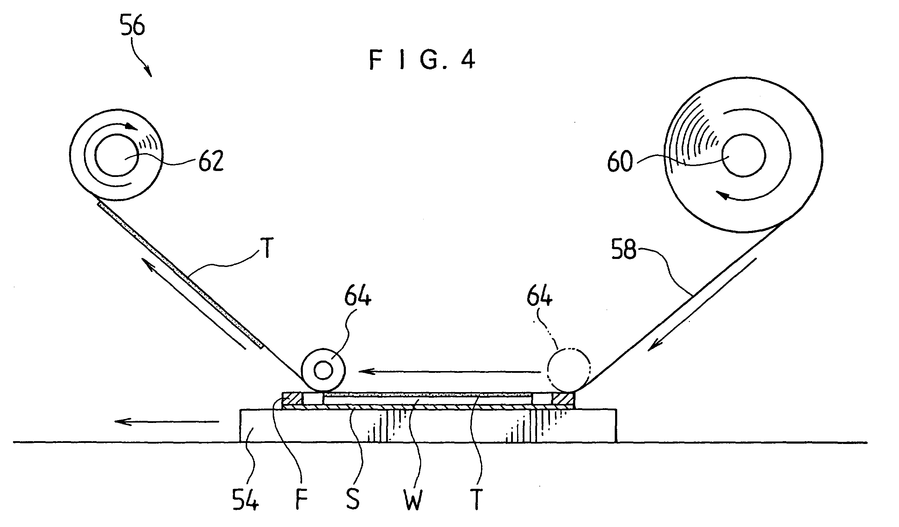

As shown in Fig. 4, the masking tape separating device 56 has an adhesive tape supply roller 60, around which a strip of adhesive tape 58 is wound, an adhesive tape take-up roller 62, which winds up the adhesive tape 58 that is fed from the adhesive tape supply roller 60, and an adhesive tape press roller 63, which presses the adhesive tape 58 against the top face of the semiconductor wafer W so as to adhere the adhesive tape 58. The adhesive tape 58 that is fed from the adhesive tape supply roller 60 with the adhesion face turned down is pressed against the top face of the semiconductor wafer W by the adhesion tape press roller 63 and is adhered to the masking tape T between the adhesive tape supply roller 60 and the adhesive tape take-up roller 62. The adhesive tape 58 that is adhered to the masking tape T is wound by the adhesive tape take-up roller 62 by following the movement of the second moving table 54, and the masking tape T is thereby separated from the semiconductor wafer W.

The wafer frame supply/collection part 22 supplies the empty wafer frame F, which is contained in a wafer frame supply cassette 64, to the wafer sheet adhesion part 16, and also houses the semiconductor wafer W from which the masking tape T has been separated by the masking tape separation part 20, in a wafer frame collection cassette 66 together with the wafer frame F. The wafer frame supply/collection part 22 is provided with a wafer frame supply port 68, a wafer frame collection port 70, and a wafer frame handling robot 72.

The wafer frame supply cassette 64 is mounted at the wafer frame supply port 68, and the wafer frame collection cassette 66 is mounted at the wafer frame collection port 70. The wafer frame supply cassette 64 and the wafer frame collection cassette 66 are both constructed to be capable of housing a predetermined number of wafer frames F. The wafer frame supply port 68 is provided with the wafer frame supply cassette 64 in which a predetermined number of empty wafer frames F are housed, and the wafer frame collection port 70 is provided with the empty wafer frame collection cassette 66.

The wafer frame handling robot 72 comprises a slide table 76, which reciprocally moves on a guide rail 74 in the x-direction in Fig. 2, a first arm 78, which is rotatably provided on the slide table 76, a second arm 80, which is rotatably provided at the tip of the first arm 78, and a third arm 82, which is rotatably provided at the tip of the second arm 80. The wafer frame F is held by a clamper (not shown), which is provided on the tip of the third arm 82, and is transported.

The description of the operation of the wafer attaching apparatus 10 of the present embodiment, which is constructed as described above will be presented.

First, the semiconductor wafer W is brought in the wafer attaching apparatus 10 from the adjacent planarization apparatus 100 by the wafer handling robot 24. At this process, the semiconductor wafer W is held by the wafer handling robot 24 with its obverse, over which the masking tape T is adhered, turned down. Since the obverse of the semiconductor wafer W is covered with the masking tape T, the wafer W is not easily broken even though the wafer W is held by the wafer handling robot 24.

The semiconductor wafer W that is brought in the wafer attaching apparatus 10 is transported into the predetermined UV radiation position of the UV radiation part 14. Then, the UV light is radiated from the UV radiation unit 30 onto the bottom face of the semiconductor wafer W, that is, the face to which the masking tape T is adhered, while the wafer W is held by the wafer handling robot 24. The adhesive of the masking tape T is hardened due to the action of the UV rays, and the masking tape T thus becomes easily separable from the semiconductor wafer W.

The semiconductor wafer W to which the UV light has been radiated is then transported by the wafer handling robot 24 onto the first moving table 32 of the wafer sheet adhesion part 16. At this process, the first moving table 32 is positioned at the predetermined wafer receiving position. The semiconductor wafer W is positioned and mounted at the predetermined position of the first moving table 32 and held. As shown in Fig. 1(a), the semiconductor wafer W is mounted on the first moving table 32 with the obverse, to which the adhesion tape T is adhered, turned down.

Next, the wafer frame handling robot 72 picks up the empty wafer frames F from the wafer frame supply cassette 64, which is set at the wafer frame supply port 68. Then, the wafer frame F is positioned and mounted at the predetermined position on the first moving table 32 and fixed. Thereby, the semiconductor wafer W is positioned at the predetermined position within the wafer frame F as shown in Fig. 1(a).

Then, the first moving table 32 moves in the y-direction in Fig. 2, and moves to the predetermined wafer sheet adhesion position. The wafer sheet S is adhered to the wafer frame F and the top face of the semiconductor wafer W by the wafer sheet adhering device 34. After the adhesion, the remaining outer periphery of the wafer sheet S is cut off by the wafer sheet cutting device 36. Thus, the wafer sheet S is adhered to the wafer frame F and at the same time the semiconductor wafer W is adhered to the wafer sheet S as shown in Fig. 1(b). In this state, the semiconductor wafer W is positioned with its reverse, to which no masking tape is adhered, turned up, and the wafer sheet S is adhered to the reverse.

Next, the first moving table 32 moves in the y-direction in Fig. 2 and moves to the predetermined wafer frame delivery position. At this process, the strip of the wafer sheet S moves by following the movement of the first moving table 32, and the remaining wafer sheet S is separated from the wafer frame F and wound by the wafer sheet take-up roller 40.

When the first moving table 32 moves to the wafer frame delivery position and the fixation to the wafer W and the wafer frame F is released, the side of the wafer frame F mounted on the first moving table 32 is held by the damper 52 of the wafer frame turning device 48. The wafer frame turning device 48 then rotates the output shaft of the rotary actuator 50 by 180° to turn the wafer frame F held by the damper 52 by 180°. Thereby, the wafer frame F is mounted on the second moving table 54, which is positioned at the predetermined wafer frame receiving position. In this process, the wafer frame F is mounted on the second moving table 54 after being turned upside down, that means, in the state where the face (obverse) to which the masking tape T is adhered is turned up as shown in Fig. 1(c).

As mounting the wafer frame F on the second moving table 54, the wafer frame F is released from the damper 52, and the wafer W and the wafer frame F are fixed onto the second moving table 54 by, for example, a suction means. After the process, the second moving table 54 moves to the predetermined masking tape separation position.

As the second moving table 54 moves to the masking tape separation position, the masking tape separating device 56 adheres the adhesion tape 58 to the masking tape T on the obverse of the semiconductor wafer W. After the adhesion, the second moving table 54 moves toward the predetermined wafer delivery position. At this process, the strip of the adhesion tape 58 moves by following the movement of the second moving table 54, and the adhesion tape 58 is wound on the adhesion tape take-up roller 62. Thereby, the masking tape T is separated from the obverse of the semiconductor wafer W as shown in Fig. 1(d), and is wound by the adhesion tape take-up roller 62 with the adhesion tape 58.

As the second moving table 54 moves to the wafer delivery position and the fixation to the wafer W and the wafer frame F is released, the wafer frame handling robot 72 picks up the wafer frame F from the second moving table 54. Then, the wafer frame handling robot 72 houses the wafer frame F in the empty wafer frame collection cassette 66, which is set in the wafer frame collection port 70.

Through the successive process described above, an operation for adhering the first semiconductor wafer W is completed, and sequentially the second wafer and so forth is processed in the same procedure.

As described above, according to the wafer attaching apparatus 10 in the present embodiment, the adhering operation of the semiconductor wafer W can be performed automatically, and thus the production efficiency of the semiconductor wafer W can be improved.

Moreover, the semiconductor wafer W is separated while being adhered to the wafer sheet S of the wafer frame F when the masking tape T is separated from the obverse of the semiconductor wafer W; and hence, the semiconductor wafer W is not easily broken.

Furthermore, the semiconductor wafer W is always handled in the state where the wafer W is protected by some protection member; and hence, the semiconductor wafer W is not broken during transportation.

The wafer attaching apparatus 10 in the present embodiment is constructed to directly bring the semiconductor wafer W therein from the planarization apparatus 100, in which the reverse of the wafer W is polished; however, a cassette port may be provided for setting the cassettes in which number of semiconductor wafers W are housed in order to bring the semiconductor wafer W in the wafer attaching apparatus 10 from the cassettes. In addition, although the description is omitted in the embodiment, including the wafer attaching apparatus into the planarization apparatus improves the effect even more.

The wafer attaching apparatus 10 in the present embodiment is constructed to collect the semiconductor wafer W that is adhered to the wafer frame F into the wafer frame collection cassette 66; however the semiconductor wafer W that is adhered to the wafer frame F may be directly brought in the dicing machine.

As described above, in accordance with the present invention, the wafer can be separated from the masking tape and attached to the wafer frame for dicing without being damaged.

It should be understood, however, that there is no intention to limit the invention to the specific forms disclosed, but on the contrary, the invention is to cover all modifications, alternate constructions and equivalents falling within the spirit and scope of the invention.

## Claims

1. A method for attaching a wafer (W) to a wafer frame (F) in particular for dicing, a masking tape (T) being attached on an observe of the wafer (W), the method comprising the steps of:
adhering a reverse of the wafer (W) to a wafer sheet (S) adhered to the wafer frame (F); and
then separating the masking tape (T) from the wafer (W).

2. The method as defined in claim 1, further comprising the step of:
before the adhering step, processing the reserve of the wafer (W) by a planarization apparatus (100), the masking tape (T) being attached on the observe of the wafer (W).

3. A wafer attaching apparatus (10) which attaches a wafer (W) to a wafer frame (F) in particular for dicing, a masking tape (T) being attached on an obverse of the wafer (W), the apparatus (10) comprising:
a wafer sheet adhering device (16) which adheres a reserve of the wafer (W) to a wafer sheet (S) adhered to the wafer frame (F); and
a masking tape separating device (20) which separates the masking tape (T) from the wafer (W) adhered to the wafer sheet (S).

4. The wafer attaching apparauts as defined in claim 3, further comprising a transporting device (12) which transports the wafer (W) from a planarization apparatus (100) to the wafer attaching apparauts (10), the reserve of the wafer (W) being processed by the planarization apparatus (100).

5. A planarization apparatus which processes a reverse of the wafer (W), a masking tape (T) being attached on an obverse of the wafer (W), comprising the wafer attaching apparatus (10) as defined in claim 3.
